# EUROPEAN PATENT APPLICATION

(11) **EP 4 718 955 A1**
(43) Date of publication of application: **01.04.2026**
(21) Application number: 25195424.4
(22) Date of filing: 12.08.2025
(51) Int. Cl.: H05K 3/40, H05K 1/181, H05K 1/11, H05K 3/325

(54) **FLEXIBLE MOUNTING STRUCTURES FOR SURFACE MOUNT COMPONENTS**

(30) Priority: 27.09.2024 US 202418899209
(71) Applicant: INTEL Corporation, Santa Clara, CA 95054 (US)
(72) Inventor: LIM, Min Suet, Gelugor (MY); LIM, Seok Ling, Bukit Mertajam (MY); GOH, Eng Huat, Ayer Itam (MY); KU, Jeff, Taipei City (TW); NAGARAJAN, Kavitha, Bangalore (IN); KONG, Jackson C. P., Tanjung Tokong (MY)
(74) Representative: Rummler, Felix

(57) **Abstract**

In one embodiment, an apparatus includes a circuit board (e.g., a motherboard) having conductive contacts that are integral with and extend away from a first metal layer of the circuit board. The contacts may extend away from the circuit board at an angle less than 90 degrees (e.g., less than 45 degrees in some embodiments). The contacts may include flat surfaces that are elevated away from and generally parallel with the upper surface of the circuit board.

## Description

### BACKGROUND

Next generation computing devices will require larger numbers of processors (e.g., CPUs, GPUs, NPUs, etc.). These additional processors will require higher (and cleaner) amounts of power to be supplied, meaning that the computing systems will require more power rails and capacitors. The latter may pose some issues for acoustic noise targets for the computing systems, as certain capacitors (e.g., multilayer ceramic capacitors (MLCCs)) can contribute significantly to system noise.

### BRIEF DESCRIPTION OF THE DRAWINGS

FIG. 1A illustrates a side view of a first example flexible component mounting structure for surface mount components in accordance with embodiments herein.
FIG. 1B illustrates a perspective view of the first example flexible mounting structure shown in FIG. 1A.
FIG. 2 illustrates a second example flexible mounting structure for surface mount components in accordance with embodiments herein.
FIGS. 3A-3C illustrate a process of forming an example flexible mounting structure in a metal layer of a circuit board.
FIGS. 4A-4C illustrate another process of forming example flexible mounting structures in a metal layer of a circuit board.
FIGS. 5A-5F illustrate an example process for manufacturing a circuit board with flexible mounting structures in accordance with embodiments herein.
FIG. 6 illustrates an example motherboard implementing flexible component mounting structures of the present disclosure.
FIG. 7 illustrates an example computing device in which aspects of the present disclosure may be incorporated.
FIG. 8 illustrates a simplified block diagram of a computing device in which aspects of the present disclosure may be incorporated.
FIG. 9 is a block diagram of computing device components which may be included in a computing device incorporating aspects of the present disclosure.

### DETAILED DESCRIPTION

In the following description, specific details are set forth, but aspects of the technologies described herein may be practiced without these specific details. Well-known circuits, structures, and techniques have not been shown in detail to avoid obscuring an understanding of this description. "An embodiment," "various embodiments," "some embodiments," and the like may include features, structures, or characteristics, but not every embodiment necessarily includes the particular features, structures, or characteristics.

Some embodiments may have some, all, or none of the features described for other embodiments. "First," "second," "third," and the like describe a common object and indicate different instances of like objects being referred to. Such adjectives do not imply objects so described must be in a given sequence, either temporally or spatially, in ranking, or any other manner. "Connected" may indicate elements are in direct physical or electrical contact with each other and "coupled" may indicate elements co-operate or interact with each other, but they may or may not be in direct physical or electrical contact. Terms modified by the word "substantially" include arrangements, orientations, spacings, or positions that vary slightly from the meaning of the unmodified term. For example, description of a lid of a mobile computing device that can rotate to substantially 360 degrees with respect to a base of the mobile computing includes lids that can rotate to within several degrees of 360 degrees with respect to a device base.

The description may use the phrases "in an embodiment," "in embodiments," "in some embodiments," and/or "in various embodiments," each of which may refer to one or more of the same or different embodiments. Furthermore, the terms "comprising," "including," "having," and the like, as used with respect to aspects of the present disclosure, are synonymous.

Reference is now made to the drawings, which are not necessarily drawn to scale, wherein similar or same numbers may be used to designate same or similar parts in different figures. The use of similar or same numbers in different figures does not mean all figures including similar or same numbers constitute a single or same embodiment. Like numerals having different letter suffixes may represent different instances of similar components. The drawings illustrate generally, by way of example, but not by way of limitation, various embodiments discussed in the present document.

In the following description, for purposes of explanation, numerous specific details are set forth in order to provide a thorough understanding thereof. It may be evident, however, that the novel embodiments can be practiced without these specific details. In other instances, well known structures and devices are shown in block diagram form in order to facilitate a description thereof. The intention is to cover all modifications, equivalents, and alternatives within the scope of the claims. While aspects of the present disclosure may be used in any suitable type of computing device, the examples below describe example computing devices/environments in which aspects of the present disclosure can be implemented.

### Flexible Mounting Structures for Surface Mount Components

Aspects of the present disclosure provide flexible mounting structures for surface mount components of computing systems. These flexible mounting structures can provide quieter operation in computing systems, as some components, such as multilayer ceramic capacitors (MLCCs), are known to contribute significantly to system noise. This is because MLCCs can vibrate during operation, due to expansion and contraction of the dielectric of the capacitor from the electric field changes during operation. This vibration can lead to an audible buzzing sound that can cause poor user experience.

Existing solutions to these issues focus on the capacitor design, implementing, for example, taller capacitors, longer capacitors terminal leads, changing materials of the capacitors, and use of interposers for the capacitors. These capacitors are typically customized, making them expensive and potentially single-sourced. In contrast, embodiments herein can avoid the vibrational noise caused by traditional capacitor designs through the use of flexible mounting structures in the circuit board (as opposed to the capacitor). This can save costs by avoiding customized, expensive capacitors that may use alternative (and possibly more expensive) materials. Further, the mounting structures described herein do not need to include higher electrical or mechanical requirements than other types of connectors (e.g., CMT (compressive mounting technology) connectors).

The mounting structures proposed herein may be fabricated into a printed circuit board (PCB) directly (e.g., within the level 1 (L1) metal layer or top metal layer of the circuit board) and may include flexible component connectors that extend upward and away from an upper or top surface of the circuit board such that the connection point for the circuit component is not on the upper surface of the circuit board. These connectors can be flexible enough to absorb vibrations caused by components mounted thereto. For example, when a capacitor (e.g., MLCC) contracts/expands during operation as described above, the connectors can flex or otherwise move and absorb the stress from the vibration, similar to a spring. The connectors can include flat surfaces at an end away from the circuit board, and these flat surfaces can provide mounting points for the circuit components. The shape and/or size of the connectors can be designed to suit the various types of capacitors that might be used in a circuit board design.

Advantageously, the flexible connector/mounting structures of the present disclosure can be fabricated in existing PCB manufacturing methods. For example, these connectors can be fabricated at the same time as existing connector technologies are fabricated in the PCB manufacturing process. In some embodiments, the connector can be patterned into a top metal layer of the PCB, and the connector/mounting structure can be lifted away from the surface of the PCB later on, e.g., using a heat treatment prior to components attachment. Accordingly, embodiments of the present disclosure may provide noise reduction benefits with minimal additional manufacturing cost.

While examples herein may be described as being implemented in a motherboard of a computing system (e.g., a laptop computing system) to mount MLCCs, embodiments of the present disclosure can be implemented in any suitable type of circuit board for mounting any particular type of component, e.g., other types of components that may cause noise during operation.

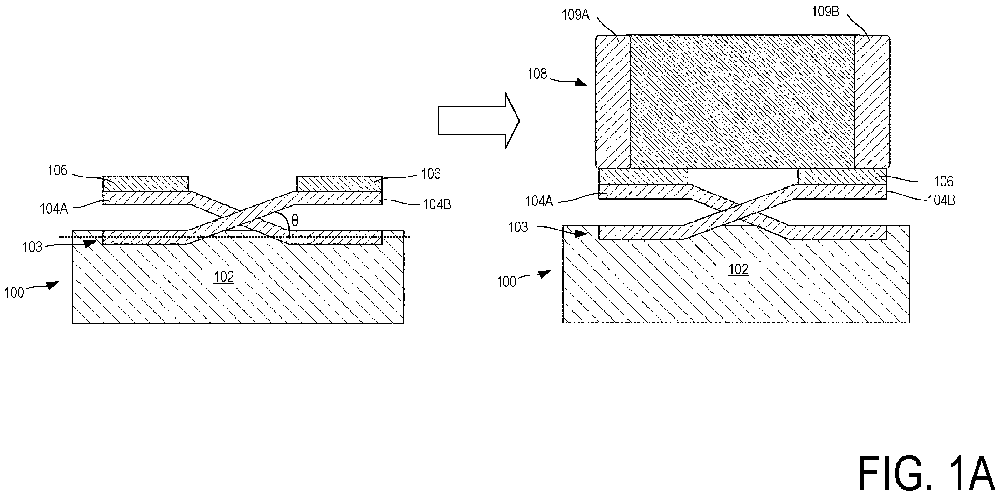

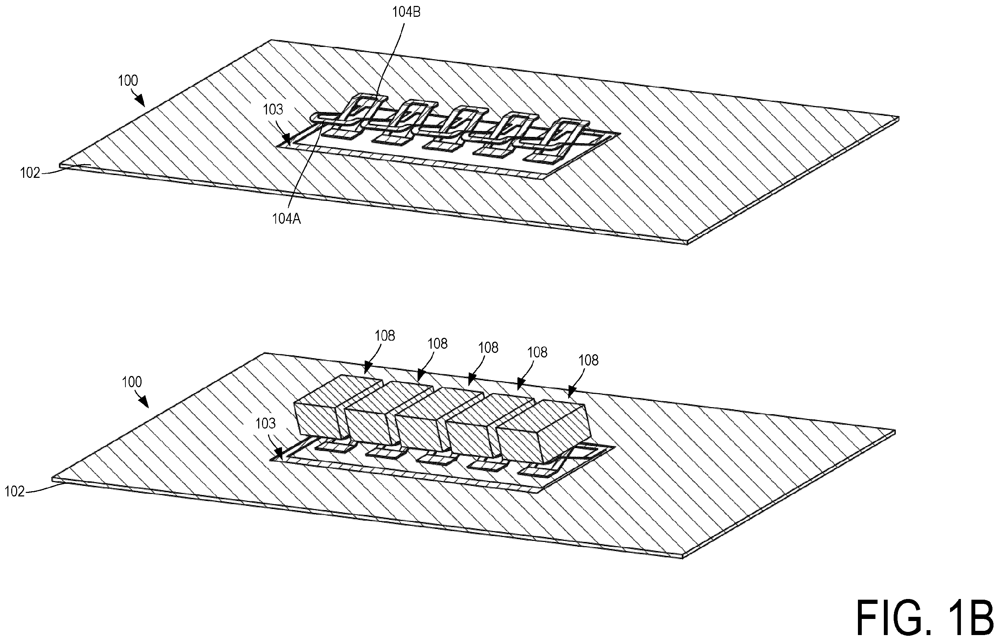

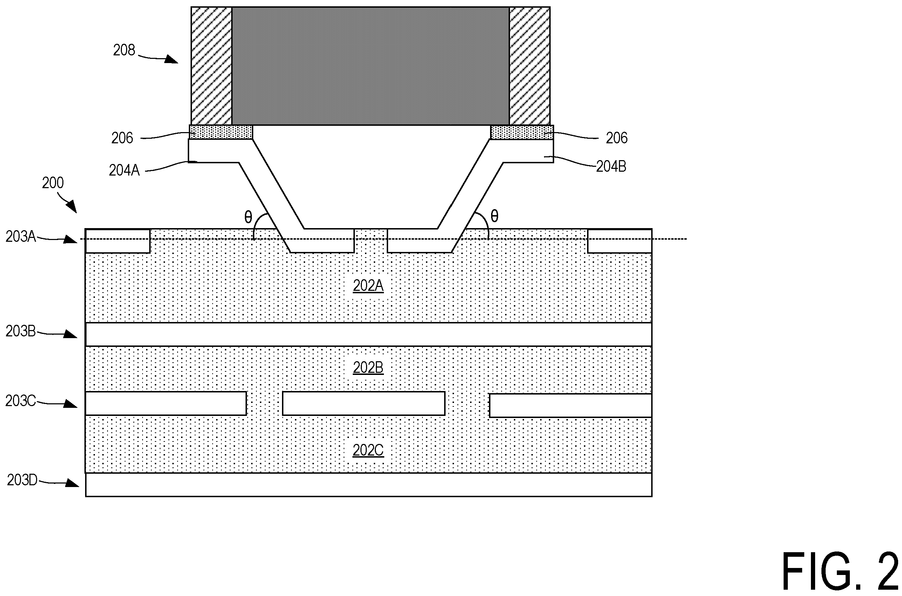

FIG. 1 illustrates a side view of a first example flexible component mounting structure for surface mount components in accordance with embodiments herein. In the example shown, there is a circuit board 100 having a dielectric substrate 102 and metal layer 103 adjacent to an upper surface of the circuit board 100. Although shown with just one metal layer 103, a circuit board in accordance with embodiments herein may include any suitable number of metal layers, separated by dielectric layers (e.g., prepreg material layers). The metal layer 103 is formed on or near the upper surface of the substrate 102 and includes a flexible component mounting structure having two connectors 104A, 104B that are integral with or formed from the metal layer 103 and extend away from the metal layer 103 and the upper surface of the substrate 102. The connectors 104A, 104B include a portion that is generally bent away from the metal layer 103 at an angle θ as shown, which may be less than 90 degrees relative to the metal layer 103 and upper surface of the circuit board 100, and in some instances, less than 45 degrees (e.g., approximately 30 degrees). The connectors 104A, 104B extend in opposite directions and cross one another as shown; however, other embodiments may include connectors that extend in opposite directions without crossing one another (in a side view), e.g., as shown in FIGS. 2, 3A-3C, and 4A-4C. As used herein, the term connectors may refer to a conductive contact of a circuit board. For example, the connectors 104A, 104B are conductive contacts of the circuit board 100 and electrically couple the component 108 with the metal layer 103.

The connectors 104A, 104B also include flat surfaces at the ends of the connectors. The flat surfaces are generally parallel with the metal layer 103 and the upper surface of the circuit board 100. These flat surfaces of the connectors 104A, 104B may be used for mounting a component 108 (e.g., a capacitor such as an MLCC). The terminals 109A, 109B of the component 108 may be attached to the flat surfaces of the connectors 104A, 104B (respectively) via solder 106. When attached, the component 108 may be elevated vertically away from the circuit board 100 as shown, and the angled connectors 104A, 104B may act as a spring and allow for damping or absorption of vibration of the component 108, e.g., vibration caused by the changing electric fields within the component 108 as described above or other forms of vibration of the component. Although shown with two connectors and terminals, embodiments herein can include flexible mounting structures having other numbers (e.g., 3, 4, or more) of connectors for attaching other types of components that may include such numbers of terminals.

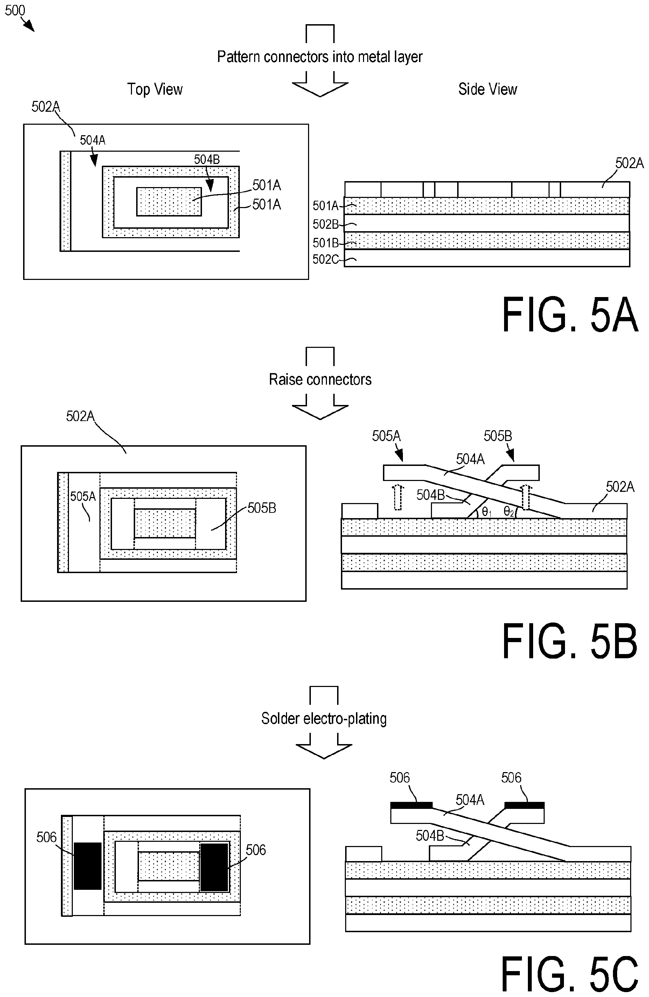

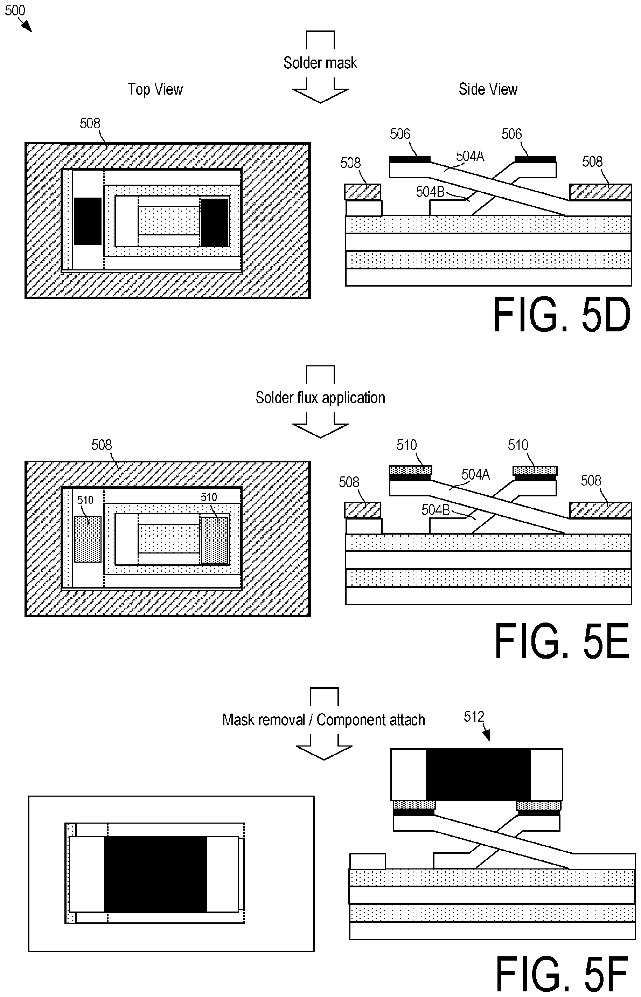

FIG. 1B illustrates a perspective view of the first example flexible mounting structure shown in FIG. 1A. As shown in FIG. 1B, the connectors 104A, 104B are generally rectangular in shape (when viewed from a top view, e.g., as shown in FIGS. 5A-5F), with each defines an opening therein, and the connector 104B is disposed within the opening of the connector 104A. This may allow for the flat mounting surfaces of the connectors 104A, 104B to be aligned with one another. In other embodiments, the connectors 104A, 104B may be formed differently.

FIG. 2 illustrates a second example flexible mounting structure for surface mount components in accordance with embodiments herein. In the example shown, there is a circuit board 200 having a multiple metal layers 203 separated by dielectric layers 202 (e.g., prepreg material layers). Although shown with a certain number of metal layers 203, a circuit board in accordance with embodiments herein may include any suitable number of metal layers. The top metal layer 203A is formed near the upper surface of the top dielectric layer 202A and includes a flexible component mounting structure having two connectors 204A, 204B extending away from the circuit board 200. The connectors 204A, 204B are formed from metal of the top metal layer 203A and are bent away from the top metal layer 203A to an angle θ as shown, which may be less than 90 degrees, and in some instances, less than 45 degrees (e.g., approximately 30 degrees). Unlike the previous example, the connectors 204A, 204B do not cross one another in the side view.

As with the previous example, though, the connectors 204A, 204B include surfaces that are generally parallel with the top metal layer 203A and the upper surface of the circuit board 200. These flat surfaces of the connectors 204A, 204B may be used for mounting a component 208 (e.g., a capacitor such as an MLCC) as shown, with the terminals 209A, 209B of the component 208 being attached to the flat surfaces of the connectors 204A, 204B (respectively) via solder 206 like the previous example. Like before, when attached, the component 208 may be elevated at a vertical distance away from the circuit board 200, and the angled connectors 204A, 204B may act as a spring and allow for damping or absorption of vibration of the component 208, e.g., vibration caused by the changing electric fields within the component 208 as described above or other forms of vibration of the component.

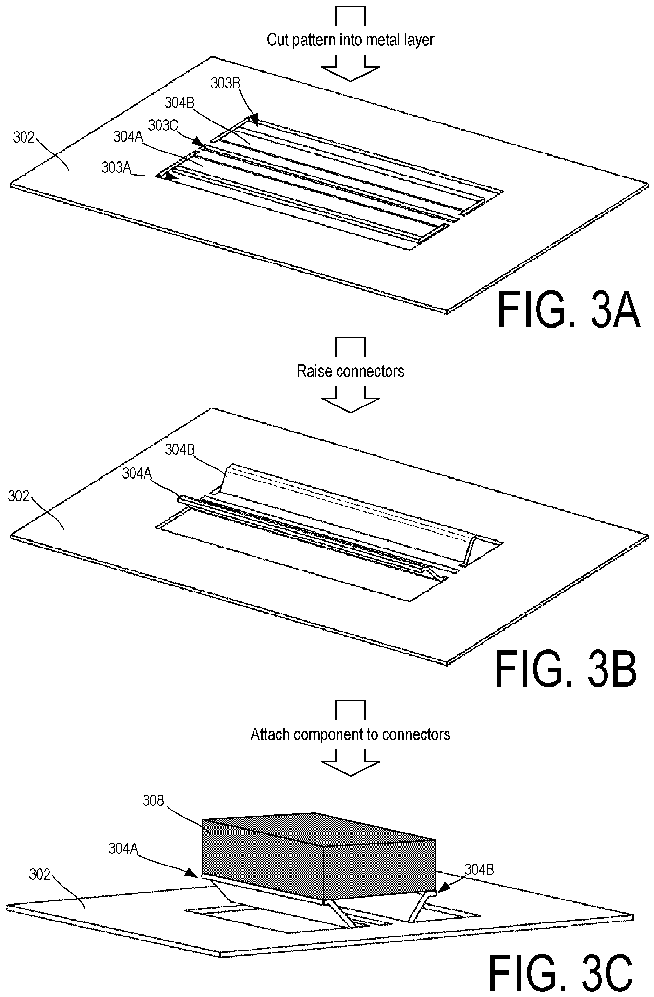

FIGS. 3A-3C illustrate a process of forming an example flexible mounting structure in a metal layer of a circuit board. The example mounting structure is similar in form to the example structure shown in FIG. 2. The process begins with patterning the connectors 304A, 304B of the mounting structure, including cutting and/or removing portions (e.g., portions 303A-C) of the metal layer 302 as shown in FIG. 3A. Then, the connectors 304A, 304B can be raised up as shown in FIG. 3B. This can be done, for example, by heating and/or mechanical means. Once raised up away from the layer 302, a component 308 can be attached to the connectors 304 as shown in FIG. 3C.

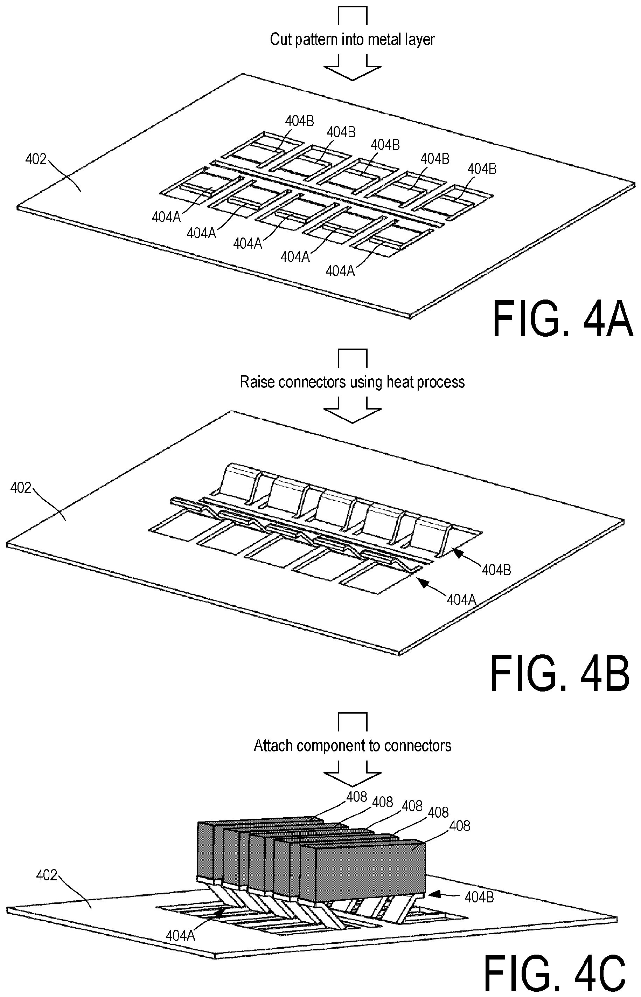

FIGS. 4A-4C illustrate another process of forming example flexible mounting structures in a metal layer of a circuit board. The example process is similar to that of FIGS. 3A-3C, except that in the former example, a single connector pair (304A, 304B) is formed in the metal layer 302, while in the present example, multiple connector pairs (404A, 404B) are formed in the metal layer 402, and different components 408 are attached to the respective connector pairs as shown in FIG. 4C.

FIGS. 5A-5F illustrate an example process 500 for manufacturing a circuit board with flexible mounting structures in accordance with embodiments herein. The example process may include additional, fewer, or other operations than those shown. Further, the operations may be performed in another order than shown, and certain operations may be performed certain operations simultaneously. The left side of each of FIGS. 5A-5F illustrates a top view of the circuit board after an operation has been performed, while the right side illustrates a side view of the circuit board after the operation has been performed.

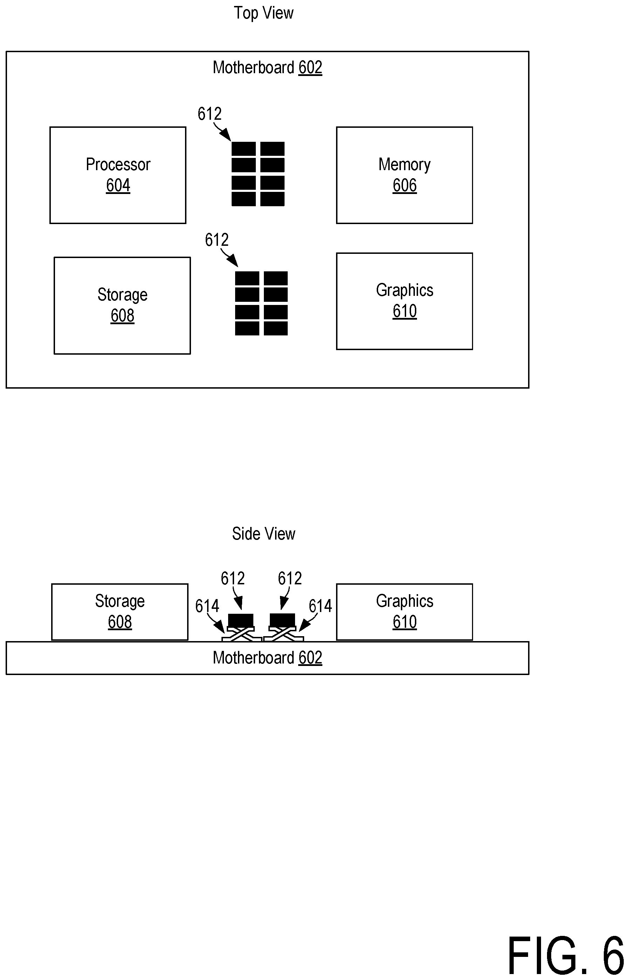

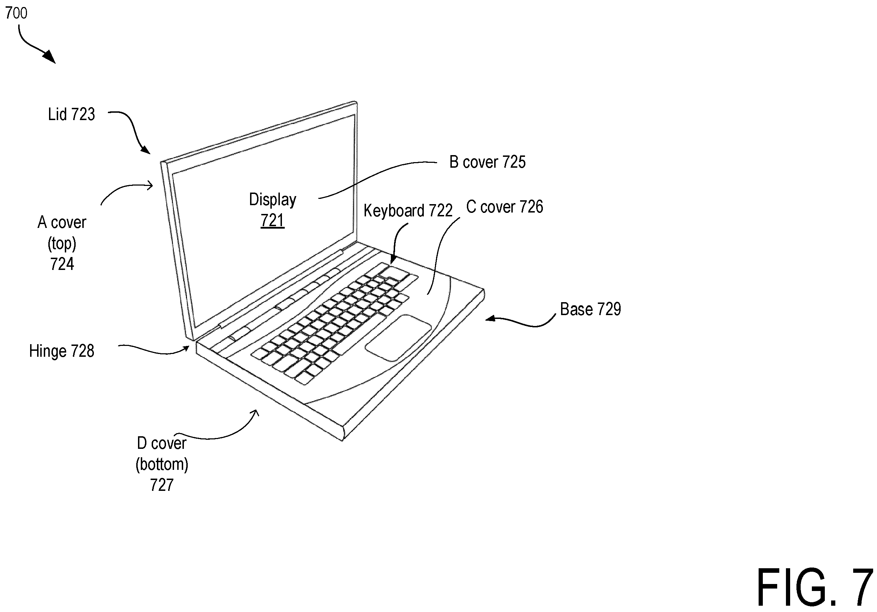

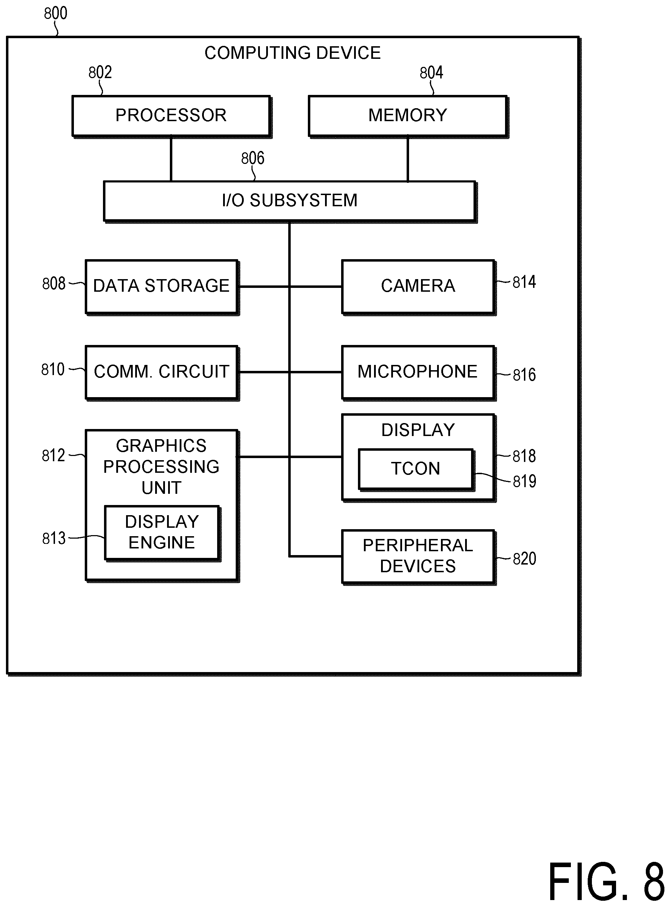

The example process 500 begins by patterning the connectors 504A, 504B into the top metal layer 502A of the circuit board, as shown in FIG. 5A. The circuit board in this example includes multiple metal layers 502A-C with dielectric layers 501A-B between each metal layer 502. The dielectric layers may be a prepreg material in certain embodiments. Although the example circuit board includes three metal layers, embodiments herein may be implemented in circuit boards having any suitable number of metal layers. In some embodiments, the circuit board is a motherboard of a computing system, e.g., a motherboard similar the motherboard 602 of FIG. 6, which can be implemented in the laptop computing device of FIG. 7, FIG. 8, or another type of computing device.

The connectors 504A, 504B are then raised up as shown in FIG. 5B. Each of the connectors may be raised at an angle (θ₁ and θ₂) with respect to the top metal layer 502A. In some embodiments, the angle of each connector 504 with respect to the top metal layer 502A may be the same, while in other embodiments, the angle of each connector 504 with respect to the top metal layer 502A may be different. The connectors 504 may be raised up using any suitable process or technique. The connectors 504 may then be formed such that they each have a surface (505A, 505B) that is generally parallel with the top metal layer 502A. Generally parallel as used herein, may refer to two surfaces being within 10 degrees of parallel with respect to one another.

Then, as shown in FIG. 5C, solder electro-plating 506 may be formed on the flat surfaces 505A, 505B of the connectors 504A, 504B. Thereafter, a solder mask 508 can be formed on the top metal layer 502A as shown in FIG. 5D, and then solder 510 can be applied to the flat surfaces 505A, 505B (via the solder electro-plating 506). The solder mask 508 can then be removed and a component 512 can be attached to the flexible mounting structure using the solder 510 as shown in FIG. 5F.

Although the example process 500 illustrates solder being electro-plated onto the connectors 504, in other embodiments, a solder paste jetting system can be used to print solder onto the flat surfaces of the connectors 504. Because such systems operate without direct surface contact, this approach can eliminate the need for z-axis movement, resulting in significantly faster production speeds compared to contact-based solder dispensing methods. Additionally, the absence of physical contact in the process can ensure consistent results, including on uneven surfaces of the connectors 504 as jetting systems excel in dispensing solder paste consistently onto surfaces with varying tolerances and different topographies. Whether it's a flat area or a raised component, the jetting system adapts to the assembly's complexity.

Once the solder paste is deposited on the flat surfaces of the connectors 504, the component 512 placed on it may adhere firmly due to the tackiness properties of the flux and subsequent reflow processes can complete the solder joint formation. In later manufacturing operations, e.g., when traditional surface mount components are being attached to the circuit board, a stepped stencil or cover may be applied to the upper surface (similar to other tall components on the board) when solder paste is being applied.

FIG. 6 illustrates an example motherboard 602 implementing flexible component mounting structures 614 of the present disclosure. The example motherboard 602 can be included in one of the example computing systems described herein, e.g., the computing devices shown in FIG. 7 or FIG. 8, or another type of computing system. The example motherboard 602 includes a processor 604, memory 606, storage device 608, and graphics processor 610 coupled thereto. The processor 604 may be implemented similar to the processors 802, 902, 904 described below, the memory 606 may be implemented similar to the memory 804, 916, 918 described below, the storage device 608 may be implemented similar to the data storage 808 or storage device 990 described below, and the graphics processor 610 may be implemented similar to the graphics processing unit 812 or graphics module 952 described below. In addition, the motherboard 602 includes circuit components 612 (e.g., capacitors or inductors) coupled thereto via the flexible mounting structures 614, which are formed similar to the example structure shown in FIG. 1. However, the mounting structures 614 may be formed in another manner, e.g., similar to the other examples shown herein.

### Example Computing Systems

FIG. 7 illustrates an example laptop computing device 700 in which aspects of the present disclosure may be incorporated. The computing device 700 can be a laptop (as shown) or another type of mobile computing device with a similar form factor, such as a foldable tablet or smartphone. In some embodiments, embodiments of present disclosure may be incorporated into a free-standing display monitor, which may be connected to a computing device that outputs image data to the display.

The computing device 700 includes a lid 723 with an A cover 724 that is a "world-facing" surface of the lid 723 when the computing device 700 is in a closed configuration and a B cover 725 that comprises a user-facing display 721 when the lid 723 is open (e.g., as shown). The computing device 700 also includes a base 729 with a C cover 726 that includes a keyboard 722 that is upward facing when the device 700 is an open configuration (e.g., as shown) and a D cover 727 that forms the bottom of the base 729. In some embodiments, the base 729 includes the primary computing resources (e.g., host processor unit(s), graphics processing unit (GPU)) of the device 700, along with a battery, memory, and storage, and communicates with the lid 723 via wires that pass through a hinge 728 that connects the base 729 with the lid 723. In some embodiments, the computing device 700 can be a dual display device with a second display comprising a portion of the C cover 726. For example, in some embodiments, an "always-on" display (AOD) can occupy a region of the C cover below the keyboard that is visible when the lid 723 is closed. In other embodiments, a second display covers most of the surface of the C cover and a removable keyboard can be placed over the second display or the second display can present a virtual keyboard to allow for keyboard input.

FIG. 8 illustrates a simplified block diagram of a computing device in which aspects of the present disclosure may be incorporated. The computing device 800 for selective updating of a display is shown. In use, the illustrative computing device 800 determines one or more regions of a display to be updated. For example, a user may move a cursor and a clock may change from one frame to the next, requiring an update to two regions of a display. The computing device 800 sends update regions from a source to a sink in the display 818 over a link. In the illustrative embodiment, the source does not have direct access to the link port while the sink does have direct access to the link port. The source can send an indication that a particular update message is the last message to be sent for the current frame, after which the source will be entering an idle period without sending update messages. The sink can then place the link in a low-power state to reduce power usage.

The computing device 800 may be embodied as any type of computing device. For example, the computing device 800 may be embodied as or otherwise be included in, without limitation, a server computer, an embedded computing system, a System-on-a-Chip (SoC), a multiprocessor system, a processor-based system, a consumer electronic device, a smartphone, a cellular phone, a desktop computer, a tablet computer, a notebook computer, a laptop computer, a network device, a router, a switch, a networked computer, a wearable computer, a handset, a messaging device, a camera device, and/or any other computing device. In some embodiments, the computing device 800 may be located in a data center, such as an enterprise data center (e.g., a data center owned and operated by a company and typically located on company premises), managed services data center (e.g., a data center managed by a third party on behalf of a company), a co-located data center (e.g., a data center in which data center infrastructure is provided by the data center host and a company provides and manages their own data center components (servers, etc.)), cloud data center (e.g., a data center operated by a cloud services provider that host companies applications and data), and an edge data center (e.g., a data center, typically having a smaller footprint than other data center types, located close to the geographic area that it serves).

The illustrative computing device 800 includes a processor 802, a memory 804, an input/output (I/O) subsystem 806, data storage 808, a communication circuit 810, a graphics processing unit 812, a camera 814, a microphone 816, a display 818, and one or more peripheral devices 820. In some embodiments, one or more of the illustrative components of the computing device 800 may be incorporated in, or otherwise form a portion of, another component. For example, the memory 804, or portions thereof, may be incorporated in the processor 802 in some embodiments. In some embodiments, one or more of the illustrative components may be physically separated from another component.

The processor 802 may be embodied as any type of processor capable of performing the functions described herein. For example, the processor 802 may be embodied as a single or multi-core processor(s), a single or multi-socket processor, a digital signal processor, a graphics processor, a neural network compute engine, an image processor, a microcontroller, or other processor or processing/controlling circuit. Similarly, the memory 804 may be embodied as any type of volatile or non-volatile memory or data storage capable of performing the functions described herein. In operation, the memory 804 may store various data and software used during operation of the computing device 800 such as operating systems, applications, programs, libraries, and drivers. The memory 804 is communicatively coupled to the processor 802 via the I/O subsystem 806, which may be embodied as circuitry and/or components to facilitate input/output operations with the processor 802, the memory 804, and other components of the computing device 800. For example, the I/O subsystem 806 may be embodied as, or otherwise include, memory controller hubs, input/output control hubs, firmware devices, communication links (i.e., point-to-point links, bus links, wires, cables, light guides, printed circuit board traces, etc.) and/or other components and subsystems to facilitate the input/output operations. The I/O subsystem 806 may connect various internal and external components of the computing device 800 to each other with use of any suitable connector, interconnect, bus, protocol, etc., such as an SoC fabric, PCIe^{®}, USB2, USB3, USB4, NVMe^{®}, Thunderbolt^{®}, and/or the like. In some embodiments, the I/O subsystem 806 may form a portion of a system-on-a-chip (SoC) and be incorporated, along with the processor 802, the memory 804, and other components of the computing device 800 on a single integrated circuit chip.

The data storage 808 may be embodied as any type of device or devices configured for the short-term or long-term storage of data. For example, the data storage 808 may include any one or more memory devices and circuits, memory cards, hard disk drives, solid-state drives, or other data storage devices.

The communication circuit 810 may be embodied as any type of interface capable of interfacing the computing device 800 with other computing devices, such as over one or more wired or wireless connections. In some embodiments, the communication circuit 810 may be capable of interfacing with any appropriate cable type, such as an electrical cable or an optical cable. The communication circuit 810 may be configured to use any one or more communication technology and associated protocols (e.g., Ethernet, Bluetooth^{®}, Wi-Fi^{®}, WiMAX, near field communication (NFC), etc.). The communication circuit 810 may be located on silicon separate from the processor 802, or the communication circuit 810 may be included in a multi-chip package with the processor 802, or even on the same die as the processor 802. The communication circuit 810 may be embodied as one or more add-in-boards, daughtercards, network interface cards, controller chips, chipsets, specialized components such as a field-programmable gate array (FPGA) or application-specific integrated circuit (ASIC), or other devices that may be used by the computing device 800 to connect with another computing device. In some embodiments, communication circuit 810 may be embodied as part of a system-on-a-chip (SoC) that includes one or more processors or included on a multichip package that also contains one or more processors. In some embodiments, the communication circuit 810 may include a local processor (not shown) and/or a local memory (not shown) that are both local to the communication circuit 810. In such embodiments, the local processor of the communication circuit 810 may be capable of performing one or more of the functions of the processor 802 described herein. Additionally or alternatively, in such embodiments, the local memory of the communication circuit 810 may be integrated into one or more components of the computing device 800 at the board level, socket level, chip level, and/or other levels.

The graphics processing unit 812 is configured to perform certain computing tasks, such as video or graphics processing. The graphics processing unit 812 may be embodied as one or more processors, data processing unit, field-programmable gate arrays (FPGAs), application-specific integrated circuits (ASICs), and/or any combination of the above. In some embodiments, the graphics processing unit 812 may send frames or partial update regions to the display 818. For instance, the example graphics processing unit 812 includes a display engine 813, which may be embodied as hardware, firmware, software, virtualized hardware, emulated architecture, and/or a combination thereof, and is configured to determine frames to be sent to the display 818 and send the images to the display 818. In the illustrative embodiment, the display engine 813 is part of the graphics processing unit 812. In other embodiments, the display engine 813 may be part of the processor 802 or other component of the device 800.

In certain embodiments, the display engine 813 may include circuitry to implement aspects of the present disclosure, e.g., circuitry to implement the computational aspects described with respect to FIG. 1 above. For example, the display engine 813 may access frames stored in the memory 804, enhance the frames as described above, and then stream the frames to the display 818.

The camera 814 may include one or more fixed or adjustable lenses and one or more image sensors. The image sensors may be any suitable type of image sensors, such as a CMOS or CCD image sensor. The camera 814 may have any suitable aperture, focal length, field of view, etc. For example, the camera 814 may have a field of view of 60-110° in the azimuthal and/or elevation directions.

The microphone 816 is configured to sense sound waves and output an electrical signal indicative of the sound waves. In the illustrative embodiment, the computing device 800 may have more than one microphone 816, such as an array of microphones 816 in different positions.

The display 818 may be embodied as any type of display on which information may be displayed to a user of the computing device 800, such as a touchscreen display, a liquid crystal display (LCD), a thin film transistor LCD (TFT-LCD), a light-emitting diode (LED) display, an organic light-emitting diode (OLED) display, a cathode ray tube (CRT) display, a plasma display, an image projector (e.g., 2D or 3D), a laser projector, a heads-up display, and/or other display technology. The display 818 may have any suitable resolution, such as 7680 x 4320, 3840 x 2160, 1920 x 1200, 1920 x 1080, etc.

The display 818 includes a timing controller (TCON) 819, which includes circuitry to convert video data received from the graphics processing unit 812 into signals that drive a panel of the display 818. In some embodiments, the TCON 819 may also include circuitry to implement one or more aspects of the present disclosure. For example, the TCON 819 may enhance frames received from the graphics processing unit 812 and stream the frames to the panel of the display 818.

In some embodiments, the computing device 800 may include other or additional components, such as those commonly found in a computing device. For example, the computing device 800 may also have peripheral devices 820, such as a keyboard, a mouse, a speaker, an external storage device, etc. In some embodiments, the computing device 800 may be connected to a dock that can interface with various devices, including peripheral devices 820. In some embodiments, the peripheral devices 820 may include additional sensors that the computing device 800 can use to monitor the video conference, such as a time-of-flight sensor or a millimeter-wave sensor.

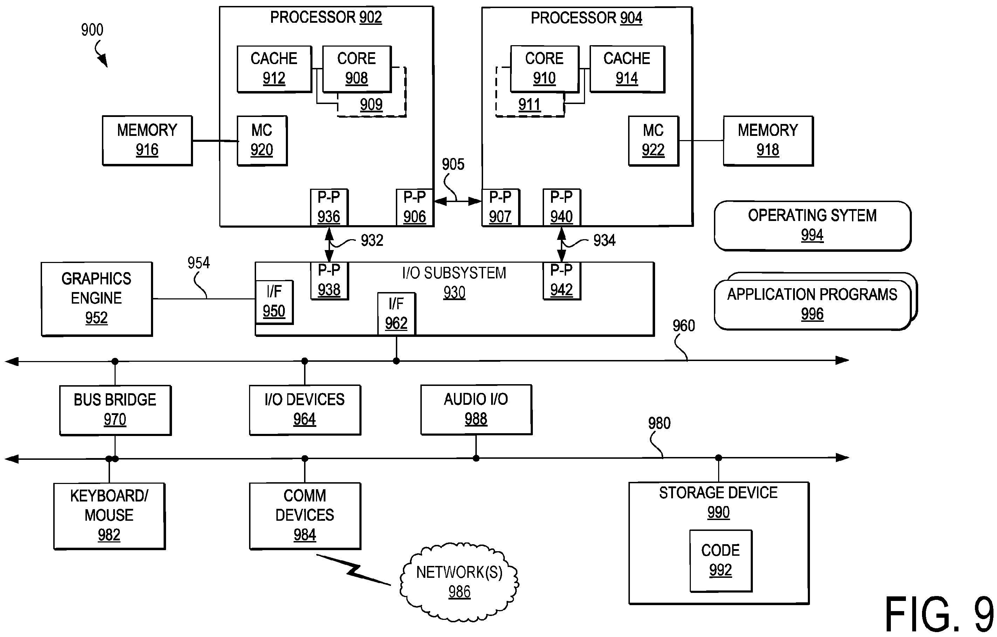

FIG. 9 is a block diagram of computing device components which may be included in a computing device incorporating aspects of the present disclosure. Generally, components shown in FIG. 9 can communicate with other shown components, although not all connections are shown, for ease of illustration. The components 900 comprise a multiprocessor system comprising a first processor 902 and a second processor 904 and is illustrated as comprising point-to-point (P-P) interconnects. For example, a point-to-point (P-P) interface 906 of the processor 902 is coupled to a point-to-point interface 907 of the processor 904 via a point-to-point interconnection 905. It is to be understood that any or all of the point-to-point interconnects illustrated in FIG. 9 can be alternatively implemented as a multi-drop bus, and that any or all buses illustrated in FIG. 9 could be replaced by point-to-point interconnects.

As shown in FIG. 9, the processors 902 and 904 are multicore processors. Processor 902 comprises processor cores 908 and 909, and processor 904 comprises processor cores 910 and 911. Processor cores 908-911 can execute computer-executable instructions in a manner similar to that discussed below, or in other manners.

Processors 902 and 904 further comprise at least one shared cache 912 and 914, respectively. The shared caches 912 and 914 can store data (e.g., instructions) utilized by one or more components of the processor, such as the processor cores 908-909 and 910-911. The shared caches 912 and 914 can be part of a memory hierarchy for the device. For example, the shared cache 912 can locally store data that is also stored in a memory 916 to allow for faster access to the data by components of the processor 902. In some embodiments, the shared caches 912 and 914 can comprise multiple cache layers, such as level 1 (L1), level 2 (L2), level 3 (L3), level 4 (L4), and/or other caches or cache layers, such as a last level cache (LLC).

Although two processors are shown, the device can comprise any number of processors or other compute resources. Further, a processor can comprise any number of processor cores. A processor can take various forms such as a central processing unit, a controller, a graphics processor, an accelerator (such as a graphics accelerator, digital signal processor (DSP), or artificial intelligence (AI) accelerator)). A processor in a device can be the same as or different from other processors in the device. In some embodiments, the device can comprise one or more processors that are heterogeneous or asymmetric to a first processor, accelerator, field programmable gate array (FPGA), or any other processor. There can be a variety of differences between the processing elements in a system in terms of a spectrum of metrics of merit including architectural, microarchitectural, thermal, power consumption characteristics and the like. These differences can effectively manifest themselves as asymmetry and heterogeneity amongst the processors in a system. In some embodiments, the processors 902 and 904 reside in a multi-chip package. As used herein, the terms "processor unit" and "processing unit" can refer to any processor, processor core, component, module, engine, circuitry or any other processing element described herein. A processor unit or processing unit can be implemented in hardware, software, firmware, or any combination thereof capable of.

Processors 902 and 904 further comprise memory controller logic (MC) 920 and 922. As shown in FIG. 9, MCs 920 and 922 control memories 916 and 918 coupled to the processors 902 and 904, respectively. The memories 916 and 918 can comprise various types of memories, such as volatile memory (e.g., dynamic random-access memories (DRAM), static random-access memory (SRAM)) or non-volatile memory (e.g., flash memory, solid-state drives, chalcogenide-based phase-change non-volatile memories). While MCs 920 and 922 are illustrated as being integrated into the processors 902 and 904, in alternative embodiments, the MCs can be logic external to a processor, and can comprise one or more layers of a memory hierarchy.

Processors 902 and 904 are coupled to an Input/Output (I/O) subsystem 930 via P-P interconnections 932 and 934. The point-to-point interconnection 932 connects a point-to-point interface 936 of the processor 902 with a point-to-point interface 938 of the I/O subsystem 930, and the point-to-point interconnection 934 connects a point-to-point interface 940 of the processor 904 with a point-to-point interface 942 of the I/O subsystem 930. Input/Output subsystem 930 further includes an interface 950 to couple I/O subsystem 930 to a graphics module 952, which can be a high-performance graphics module. The I/O subsystem 930 and the graphics module 952 are coupled via a bus 954. Alternately, the bus 954 could be a point-to-point interconnection.

Input/Output subsystem 930 is further coupled to a first bus 960 via an interface 962. The first bus 960 can be a Peripheral Component Interconnect (PCI) bus, a PCI Express (PCIe) bus, another third generation I/O (input/output) interconnection bus or any other type of bus.

Various I/O devices 964 can be coupled to the first bus 960. A bus bridge 970 can couple the first bus 960 to a second bus 980. In some embodiments, the second bus 980 can be a low pin count (LPC) bus. Various devices can be coupled to the second bus 980 including, for example, a keyboard/mouse 982, audio I/O devices 988 and a storage device 990, such as a hard disk drive, solid-state drive or other storage device for storing computer-executable instructions (code) 992. The code 992 can comprise computer-executable instructions for performing technologies described herein. Additional components that can be coupled to the second bus 980 include communication device(s) or components 984, which can provide for communication between the device and one or more wired or wireless networks 986 (e.g. Wi-Fi, cellular or satellite networks) via one or more wired or wireless communication links (e.g., wire, cable, Ethernet connection, radio-frequency (RF) channel, infrared channel, Wi-Fi channel) using one or more communication standards (e.g., IEEE 802.11 standard and its supplements).

The device can comprise removable memory such as flash memory cards (e.g., SD (Secure Digital) cards), memory sticks, Subscriber Identity Module (SIM) cards). The memory in the computing device (including caches 912 and 914, memories 916 and 918 and storage device 990) can store data and/or computer-executable instructions for executing an operating system 994, or application programs 996. Example data includes web pages, text messages, images, sound files, video data, sensor data, or other data sets to be sent to and/or received from one or more network servers or other devices by the device via one or more wired or wireless networks, or for use by the device. The device can also have access to external memory (not shown) such as external hard drives or cloud-based storage.

The operating system 994 can control the allocation and usage of the components illustrated in FIG. 9 and support one or more application programs 996. The application programs 996 can include common mobile computing device applications (e.g., email applications, calendars, contact managers, web browsers, messaging applications) as well as other computing applications.

The device can support various input devices, such as a touchscreen, microphones, cameras (monoscopic or stereoscopic), trackball, touchpad, trackpad, mouse, keyboard, proximity sensor, light sensor, pressure sensor, infrared sensor, electrocardiogram (ECG) sensor, PPG (photoplethysmogram) sensor, galvanic skin response sensor, and one or more output devices, such as one or more speakers or displays. Any of the input or output devices can be internal to, external to or removably attachable with the device. External input and output devices can communicate with the device via wired or wireless connections.

In addition, the computing device can provide one or more natural user interfaces (NUIs). For example, the operating system 994 or application programs 996 can comprise speech recognition as part of a voice user interface that allows a user to operate the device via voice commands. Further, the device can comprise input devices and components that allows a user to interact with the device via body, hand, or face gestures.

The device can further comprise one or more communication components 984. The components 984 can comprise wireless communication components coupled to one or more antennas to support communication between the device and external devices. Antennas can be located in a base, lid, or other portion of the device. The wireless communication components can support various wireless communication protocols and technologies such as Near Field Communication (NFC), IEEE 1002.11 (Wi-Fi) variants, WiMax, Bluetooth, Zigbee, 4G Long Term Evolution (LTE), Code Division Multiplexing Access (CDMA), Universal Mobile Telecommunication System (UMTS) and Global System for Mobile Telecommunication (GSM). In addition, the wireless modems can support communication with one or more cellular networks for data and voice communications within a single cellular network, between cellular networks, or between the mobile computing device and a public switched telephone network (PSTN).

The device can further include at least one input/output port (which can be, for example, a USB, IEEE 1394 (FireWire), Ethernet and/or RS-232 port) comprising physical connectors; a power supply (such as a rechargeable battery); a satellite navigation system receiver, such as a GPS receiver; a gyroscope; an accelerometer; and a compass. A GPS receiver can be coupled to a GPS antenna. The device can further include one or more additional antennas coupled to one or more additional receivers, transmitters and/or transceivers to enable additional functions.

FIG. 9 illustrates one example computing device architecture. Computing devices based on alternative architectures can be used to implement technologies described herein. For example, instead of the processors 902 and 904, and the graphics module 952 being located on discrete integrated circuits, a computing device can comprise a SoC (system-on-a-chip) integrated circuit incorporating one or more of the components illustrated in FIG. 9. In one example, an SoC can comprise multiple processor cores, cache memory, a display driver, a GPU, multiple I/O controllers, an AI accelerator, an image processing unit driver, I/O controllers, an AI accelerator, an image processor unit. Further, a computing device can connect elements via bus or point-to-point configurations different from that shown in FIG. 9. Moreover, the illustrated components in FIG. 9 are not required or all-inclusive, as shown components can be removed and other components added in alternative embodiments.

As used in any embodiment herein, the term "module" refers to logic that may be implemented in a hardware component or device, software or firmware running on a processor, or a combination thereof, to perform one or more operations consistent with the present disclosure. Software may be embodied as a software package, code, instructions, instruction sets and/or data recorded on non-transitory computer-readable storage mediums. Firmware may be embodied as code, instructions or instruction sets and/or data that are hard-coded (e.g., nonvolatile) in memory devices. As used in any embodiment herein, the term "circuitry" can comprise, for example, singly or in any combination, hardwired circuitry, programmable circuitry such as computer processors comprising one or more individual instruction processing cores, state machine circuitry, and/or firmware that stores instructions executed by programmable circuitry. Modules described herein may, collectively or individually, be embodied as circuitry that forms a part of one or more devices. Thus, any of the modules can be implemented as circuitry, such as continuous itemset generation circuitry, entropy-based discretization circuitry, etc. A computer device referred to as being programmed to perform a method can be programmed to perform the method via software, hardware, firmware or combinations thereof.

The use of reference numbers in the claims and the specification is meant as in aid in understanding the claims and the specification and is not meant to be limiting.

Any of the disclosed methods can be implemented as computer-executable instructions or a computer program product. Such instructions can cause a computer or one or more processors capable of executing computer-executable instructions to perform any of the disclosed methods. Generally, as used herein, the term "computer" refers to any computing device or system described or mentioned herein, or any other computing device. Thus, the term "computer-executable instruction" refers to instructions that can be executed by any computing device described or mentioned herein, or any other computing device.

The computer-executable instructions or computer program products as well as any data created and used during implementation of the disclosed technologies can be stored on one or more tangible or non-transitory computer-readable storage media, such as optical media discs (e.g., DVDs, CDs), volatile memory components (e.g., DRAM, SRAM), or non-volatile memory components (e.g., flash memory, solid state drives, chalcogenide-based phase-change non-volatile memories). Computer-readable storage media can be contained in computer-readable storage devices such as solid-state drives, USB flash drives, and memory modules. Alternatively, the computer-executable instructions may be performed by specific hardware components that contain hardwired logic for performing all or a portion of disclosed methods, or by any combination of computer-readable storage media and hardware components.

The computer-executable instructions can be part of, for example, a dedicated software application or a software application that is accessed via a web browser or other software application (such as a remote computing application). Such software can be read and executed by, for example, a single computing device or in a network environment using one or more networked computers. Further, it is to be understood that the disclosed technology is not limited to any specific computer language or program. For instance, the disclosed technologies can be implemented by software written in C++, Java, Perl, Python, JavaScript, Adobe Flash, or any other suitable programming language. Likewise, the disclosed technologies are not limited to any particular computer or type of hardware.

Furthermore, any of the software-based embodiments (comprising, for example, computer-executable instructions for causing a computer to perform any of the disclosed methods) can be uploaded, downloaded or remotely accessed through a suitable communication means. Such suitable communication means include, for example, the Internet, the World Wide Web, an intranet, cable (including fiber optic cable), magnetic communications, electromagnetic communications (including RF, microwave, and infrared communications), electronic communications, or other such communication means.

As used in this application and in the claims, a list of items joined by the term "and/or" can mean any combination of the listed items. For example, the phrase "A, B and/or C" can mean A; B; C; A and B; A and C; B and C; or A, B, and C. Further, as used in this application and in the claims, a list of items joined by the term "at least one of" can mean any combination of the listed terms. For example, the phrase "at least one of A, B, or C" can mean A; B; C; A and B; A and C; B and C; or A, B, and C. Moreover, as used in this application and in the claims, a list of items joined by the term "one or more of" can mean any combination of the listed terms. For example, the phrase "one or more of A, B and C" can mean A; B; C; A and B; A and C; B and C; or A, B, and C.

The disclosed methods, apparatuses and systems are not to be construed as limiting in any way. Instead, the present disclosure is directed toward all novel and nonobvious features and aspects of the various disclosed embodiments, alone and in various combinations and subcombinations with one another. The disclosed methods, apparatuses, and systems are not limited to any specific aspect or feature or combination thereof, nor do the disclosed embodiments require that any one or more specific advantages be present or problems be solved.

Although the operations of some of the disclosed methods are described in a particular, sequential order for convenient presentation, it is to be understood that this manner of description encompasses rearrangement, unless a particular ordering is required by specific language set forth herein. For example, operations described sequentially may in some cases be rearranged or performed concurrently. Moreover, for the sake of simplicity, the attached figures may not show the various ways in which the disclosed methods can be used in conjunction with other methods.

Certain non-limiting examples of the presently described techniques are provided below. Each of the following non-limiting examples may stand on its own or may be combined in any permutation or combination with any one or more of the other examples provided below or throughout the present disclosure.

Example 1 is an apparatus comprising: a circuit board comprising: a first metal layer adjacent an upper surface of the circuit board; and conductive contacts integral with and extending away from the first metal layer.

Example 2 includes the apparatus of Example 1, wherein the conductive contacts extend away from the first metal layer at an angle less than approximately 90 degrees.

Example 3 includes the apparatus of Example 1 or 2, wherein the conductive contacts each comprise a first portion that is at an angle relative to the upper surface of the circuit board and a second portion that is substantially parallel with the upper surface of the circuit board.

Example 4 includes the apparatus of Example 3, wherein the first portion is at an angle of less than approximately 45 degrees with respect to the upper surface of the circuit board.

Example 5 includes the apparatus of Example 3, wherein the second portion is at a vertical distance from the upper surface of the circuit board.

Example 6 includes the apparatus of any one of Examples 1-5, wherein a first conductive contact of the conductive contacts extends away from the first metal layer at a first angle and a second conductive contact of the conductive contacts extends away from the first metal layer at a second angle different from the first angle.

Example 7 includes the apparatus of any one of Examples 1-6, wherein a first conductive contact defines an opening and a second conductive contact is disposed within the opening of the first conductive contact.

Example 8 includes the apparatus of any one of Examples 1-7, wherein the circuit board comprises a plurality of metal layers.

Example 9 includes the apparatus of any one of Examples 1-8, further comprising a circuit component coupled to two of the conductive contacts using solder.

Example 10 includes the apparatus of Example 9, wherein the circuit component is a multilayer ceramic capacitor (MLCC).

Example 11 is an apparatus comprising: a circuit board comprising conductive contacts integral with and extending away from an upper metal layer of the circuit board, the conductive contacts comprising a flat surface that is elevated vertically from the upper surface of the circuit board; and one or more circuit components coupled to the conductive contacts.

Example 12 includes the apparatus of Example 11, wherein the conductive contacts extend away from the upper metal layer at an angle less than 90 degrees.

Example 13 includes the apparatus of Example 11 or 12, wherein the conductive contacts each comprise a first portion that is at an angle relative to the upper surface of the circuit board and a second portion that includes the flat surface.

Example 14 includes the apparatus of Example 13, wherein the first portion is at an angle of less than 45 degrees with respect to the upper surface of the circuit board.

Example 15 includes the apparatus of any one of Examples 11-14, wherein a first conductive contact extends away from the upper metal layer at a first angle and a second conductive contact extends away from the upper metal layer at a second angle different from the first.

Example 16 includes the apparatus of any one of Examples 11-15, wherein a first conductive contact defines an opening and a second conductive contact is disposed within the opening of the first conductive contact.

Example 17 includes the apparatus of any one of Examples 11-16, wherein the circuit board comprises a plurality of metal layers.

Example 18 includes the apparatus of any one of Examples 11-17, wherein the circuit components comprise multilayer ceramic capacitors (MLCCs).

Example 19 is a computing device comprising: a motherboard; a processor coupled to the motherboard; memory coupled to the motherboard; and circuit components coupled to the motherboard, wherein at least one circuit component is coupled to the motherboard via conductive contacts that are integral with and extend upward from a first metal layer of the motherboard.

Example 20 includes the computing device of Example 19, wherein the conductive contacts extend away from the first metal layer at an angle less than 90 degrees.

Example 21 includes the computing device of Example 19 or 20, wherein the conductive contacts each comprise a first portion that is at an angle relative to an upper surface of the motherboard and a second portion that is flat and approximately parallel with the upper surface of the motherboard.

Example 22 includes the computing device of Example 21, wherein the first portion is at an angle of less than 45 degrees with respect to the upper surface of the motherboard.

Example 23 includes the computing device of any one of Examples 19-22, wherein a first conductive contact extends away from the first metal layer at a first angle and a second conductive contact extends away from the first metal layer at a second angle different from the first.

Example 24 includes the computing device of any one of Examples 19-23, wherein a first conductive contact defines an opening and a second conductive contact is disposed within the opening of the first conductive contact.

Example 25 includes the computing device of any one of Examples 19-24, wherein the motherboard comprises a plurality of metal layers.

Example 26 includes the computing device of any one of Examples 19-25, wherein the circuit components comprise multilayer ceramic capacitors (MLCCs).

## Claims

1. An apparatus comprising:
a circuit board comprising:
a first metal layer adjacent an upper surface of the circuit board; and
conductive contacts integral with and extending away from the first metal layer.

2. The apparatus of claim 1, wherein the conductive contacts extend away from the first metal layer at an angle less than approximately 90 degrees.

3. The apparatus of claim 1 or 2, wherein the conductive contacts each comprise a first portion that is at an angle relative to the upper surface of the circuit board and a second portion that is substantially parallel with the upper surface of the circuit board.

4. The apparatus of claim 3, wherein the first portion is at an angle of less than approximately 45 degrees with respect to the upper surface of the circuit board.

5. The apparatus of claim 3, wherein the second portion is at a vertical distance from the upper surface of the circuit board.

6. The apparatus of any one of claims 1-5, wherein a first conductive contact of the conductive contacts extends away from the first metal layer at a first angle and a second conductive contact of the conductive contacts extends away from the first metal layer at a second angle different from the first angle.

7. The apparatus of any one of claims 1-6, wherein a first conductive contact defines an opening and a second conductive contact is disposed within the opening of the first conductive contact.

8. The apparatus of any one of claims 1-5, wherein a first conductive contact of the conductive contacts extends away from the first metal layer at a first angle and a second conductive contact of the conductive contacts extends away from the first metal layer at the first angle.

9. A device comprising:
the apparatus of any preceding claim; and
circuit components coupled to the conductive contacts of the circuit board.

10. The device of claim 9, comprising a first circuit component is coupled to a first pair of conductive contacts.

11. The device of claim 10, comprising a second circuit component is coupled to the first pair of conductive contacts.

12. The device of any one of claims 9-11, wherein the circuit components comprise multilayer ceramic capacitors (MLCCs).

13. The device of any one of claims 9-12, further comprising a processor and memory.

14. The device of claim 13, wherein the processor and memory are coupled to the circuit board.

15. The device of any one of claims 9-14, wherein the device is a laptop computing device.
